(19) **Europäisches Patentamt**
**European Patent Office**
**Office européen des brevets**

(11) **EP 3 595 332 B1**

(12) **EUROPÄISCHE PATENTSCHRIFT**

(45) Veröffentlichungstag und Bekanntmachung des Hinweises auf die Patenterteilung:
**20.03.2024 Patentblatt 2024/12**

(21) Anmeldenummer: **19186136.8**

(22) Anmeldetag: **12.07.2019**

(51) Internationale Patentklassifikation (IPC):
**H04R 17/00** (2006.01)

(52) Gemeinsame Patentklassifikation (CPC):
**H04R 17/00**

(54) **VORRICHTUNG ZUR AUDIOSIGNALVERARBEITUNG FÜR EINEN PIEZOELEKTRISCHEN LAUTSPRECHER**

AUDIO SIGNAL PROCESSING DEVICE FOR PIEZOELECTRIC LOUDSPEAKER

DISPOSITIF DE TRAITEMENT DE SIGNAL AUDIO POUR UN HAUT-PARLEUR PIÉZOÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.07.2018 DE 102018116924**

(43) Veröffentlichungstag der Anmeldung:
**15.01.2020 Patentblatt 2020/03**

(73) Patentinhaber: **Usound GmbH**
**8020 Graz (AT)**

(72) Erfinder:
• **RUSCONI CLERICI BELTRAMI, Andrea**
**1130 Wien (AT)**
• **BOTTONI, Ferruccio**
**8020 Graz (AT)**
• **STRLE, Drago**
**1000 Ljubljana (SI)**

(74) Vertreter: **Canzler & Bergmeier Patentanwälte Partnerschaft mbB**
**Despag-Straße 6**
**85055 Ingolstadt (DE)**

(56) Entgegenhaltungen:
WO-A1-2004/049560  WO-A1-2011/159346
WO-A1-2012/055968  WO-A1-2013/131965
WO-A1-2018/077922  WO-A2-92/15153
DE-B3- 10 393 487  US-A1- 2007 124 620
US-A1- 2010 271 147

**Beschreibung**

Die vorliegende Erfindung betrifft eine Vorrichtung zur Audiosignalverarbeitung für einen piezoelektrischen Lautsprecher zum Erzeugen von Schallwellen im hörbaren Wellenlängenspektrum. Die Vorrichtung umfasst einen Signaleingang für ein digitales Audiosignal, eine digitale Korrektureinheit zur Korrektur einer Nichtlinearität des Lautsprechers und einen digitalen PWM-Generator, mit dem das von der Korrektureinheit korrigierte Signal in ein pulsweitenmoduliertes Schaltsignal umwandelbar ist. Ferner umfasst die Vorrichtung eine Leistungsstufe, die mit dem von dem PWM-Generator umgewandelten Schaltsignal derart ansteuerbar ist, dass ein piezoelektrischer Aktor des Lautsprechers zum Auslenken einer Membran mit einer Spannung aufladbar ist. Außerdem weist die Vorrichtung einen Regelkreis ausbildende Rückkopplung auf, mit der die Spannung als Rückführsignal rückkoppelbar ist, wobei das Rückführsignal im bestimmungsgemäßen Gebrauch im hörbaren Frequenzbereich ein von der Korrektureinheit, dem PWM-Generator, der Leistungsstufe und/oder dem piezoelektrischen Lautsprecher verursachtes erstes Signalrauschen aufweist. Die vorliegende Erfindung betrifft außerdem ein Verfahren zur Audiosignalverarbeitung für einen piezoelektrischen Lautsprecher zum Erzeugen von Schallwellen im hörbaren Wellenlängenspektrum.

Aus der US 2010/0271147 A1 ist eine Vorrichtung zum Betreiben eines piezoelektrischen Lautsprechers bekannt. Nachteilig daran ist, dass eine Tonqualität des Lautsprechers nicht ausreichend ist.

Dokument WO 2012/055968 A1 offenbart ein Audioverstärker mit mehrstufiger Pulsbreitenmodulation.

Aufgabe der vorliegenden Erfindung ist es somit, die Tonqualität der vom piezoelektrischen Lautsprecher ausgegebenen Schallwellen zu verbessern.

Die Aufgabe wird gelöst durch eine Vorrichtung zur Audiosignalverarbeitung für einen piezoelektrischen Lautsprecher sowie dem dazugehörigen Verfahren mit den Merkmalen der unabhängigen Patentansprüche.

Vorgeschlagen wird eine Vorrichtung zur Audiosignalverarbeitung für einen piezoelektrischen Lautsprecher zum Erzeugen von Schallwellen im hörbaren Wellenlängenspektrum. Das hörbare Wellenlängenspektrum reicht für den Menschen von ungefähr 20 Hz bis 20 kHz, wobei dieser Bereich von Person zu Person unterschiedlich sein kann und insbesondere vom Alter der Person abhängen kann. Niedrigere und auch höhere Frequenzen sind für das menschliche Gehör nicht wahrnehmbar.

Die Vorrichtung weist einen Signaleingang für ein digitales Audiosignal auf. Das Audiosignal kann beispielsweise Musik, Töne und/oder Sprache umfassen, welche von einem Smartphone, einem MP3-Player oder einem sonstigen Gerät stammen. Das Audiosignal wird dabei über den Signaleingang in die Vorrichtung eingespeist, um durch den piezoelektrischen Lautsprecher ausgegeben zu werden.

Außerdem umfasst die Vorrichtung eine digitale Korrektureinheit zur Korrektur einer Nichtlinearität des Lautsprechers. Die digitale Korrektureinheit kann das digitale Audiosignal vom Signaleingang erhalten. Die digitale Korrektureinheit kann somit in einer Signalflussrichtung dem Signaleingang nachgelagert sein. Die Nichtlinearitäten spiegeln sich darin wieder, dass eine Veränderung des digitalen Audiosignals nicht zu einer Änderung des am piezoelektrischen Lautsprechers ausgegebenen Schalls linear proportional ist. Dies kann im Wesentlichen darin begründet sein, dass der piezoelektrische Lautsprecher ein komplexes, nichtlineares Verhalten aufweist. Außerdem können Temperaturänderungen der Vorrichtung und/oder des piezoelektrischen Lautsprechers zu Nichtlinearitäten führen. Mit Hilfe der digitalen Korrektureinheit können die Nichtlinearitäten vermindert werden, so dass eine Tonqualität des piezoelektrischen Lautsprechers verbessert werden kann.

Ferner umfasst die Vorrichtung einen digitalen PWM-Generator, mit dem das von der digitalen Korrektureinheit korrigierte Signal in ein pulsweitenmoduliertes Schaltsignal umwandelbar ist. Der digitale PWM-Generator kann somit der digitalen Korrektureinheit in Signalflussrichtung nachgelagert sein.

Des Weiteren umfasst die Vorrichtung eine Leistungsstufe, die mit dem von dem PWM-Generator umgewandelten Schaltsignal derart ansteuerbar ist, dass ein piezoelektrischer Aktor des Lautsprechers zum Auslenken einer Membran mit einer Spannung aufladbar ist. Die Leistungsstufe kann dem PWM-Generator in Signalflussrichtung nachgeschaltet sein. Die Leistungsstufe kann eine Verstärkereinheit umfassen, die den piezoelektrischen Aktor des Lautsprechers mit Spannung aufladen und entladen kann. Die Leistungsstufe kann ein Ausgangssignal bereitstellen, so dass der Lautsprecher ein zum digitalen Audiosignal entsprechenden Schall, welcher Musik, Schall und/oder Töne umfassen kann, ausgeben kann. Die Leistungsstufe kann auch zumindest einen Schalter aufweisen, der das Schaltsignal des PWM-Generators verarbeiten kann.

Der piezoelektrische Lautsprecher kann von der Leistungsstufe beispielsweise mit elektrischer Energie einer Energieeinheit zumindest teilweise geladen und wieder zumindest teilweise entladen werden, wodurch die Schallwellen erzeugt werden. Die elektrische Energie kann dabei von der Energieeinheit bereitgestellt werden. Der piezoelektrische Lautsprecher weist piezoelektrische Eigenschaften auf, das heißt, der piezoelektrische Lautsprecher kann in Abhängigkeit seines Ladezustandes ausgelenkt werden. Je höher die Aufladung des piezoelektrischen Lautsprechers mit elektrischer Energie ist, desto höher ist auch die Auslenkung des piezoelektrischen Lautsprechers. Mit Hilfe der Auslenkung des piezoelektrischen Lautsprechers können die Schallwellen erzeugt werden, wenn die Auslenkung beispielsweise auf die Membran übertragen wird. Dadurch kann die über der Membran angeordnete Luft in Schwingung versetzt werden, so dass die Schallwellen erzeugt werden. Ferner kann die Auslenkung des piezoelektrischen Lautsprechers dadurch verändert werden, dass dieser geladen und entladen wird. Wird der piezoelektrische Lautsprecher weiter geladen, kann die Auslenkung vergrößert werden. Um die Auslenkung dagegen zu verringern, kann der piezoelektrische Lautsprecher entladen werden. Der piezoelektrische Lautsprecher kann somit durch abwechselndes Laden und Entladen in Schwingung versetzt werden, wobei die Schwingungen beispielsweise auf die Membran übertragen werden, so dass die Schallwellen erzeugt werden. Der piezoelektrische Lautsprecher kann dabei schrittweise geladen und/oder entladen werden.

Durch das gesteuerte Auslenken des piezoelektrischen Lautsprechers können somit Schallwellen erzeugt werden. Wenn das Auslenken gemäß dem digitalen Audiosignal erfolgt, das beispielsweise Ton, Schall oder Musik umfassen kann, wird mit Hilfe des piezoelektrischen Lautsprechers ein entsprechendes Geräusch, das ebenfalls Ton, Schall oder Musik umfasst, erzeugt. Das Audiosignal kann beispielsweise in Form einer Musikdatei vorliegen. Das Audiosignal kann aber auch beim Telefonieren von einem Gesprächspartner bereitgestellt werden.

Durch das Laden und das Entladen mit elektrischer Energie steigt bzw. sinkt auch eine elektrische Spannung am piezoelektrischen Lautsprecher. Mit steigender Spannung am piezoelektrischen Lautsprecher steigt die Auslenkung. Weiterhin verringert sich die Auslenkung, wenn die Spannung am piezoelektrischen Lautsprecher sinkt. Ferner weist der piezoelektrische Lautsprecher eine Kapazität auf, da sich durch das Aufladen des piezoelektrischen Lautsprechers mit elektrischer Energie in Abhängigkeit der elektrischen Spannung ein elektrisches Feld aufbaut. Der piezoelektrische Lautsprecher kann somit Eigenschaften eines Kondensators aufweisen. Außerdem können der Ladezustand bzw. die elektrische Spannung des piezoelektrischen Lautsprechers und die Auslenkung voneinander abhängen.

Die Leistungsstufe kann beispielsweise ein Spannungswandler sein. Mit Hilfe der Leistungsstufe kann der piezoelektrische Aktor beispielsweise auf 30V aufgeladen werden, auf wenn durch eine Energiequelle, beispielsweise eine Batterie, lediglich 3V zur Verfügung gestellt werden. Die Leistungsstufe kann den piezoelektrischen Aktor dabei beispielsweise schrittweise bzw. getaktet Aufladen. Die Aufladung des piezoelektrischen Aktors hängt dabei von dem digitalen Audiosignal ab.

Zusätzlich oder alternativ kann die Leistungsstufe den piezoelektrischen Aktor auch entladen. Dies kann durchgeführt werden, wenn die Auslenkung der Membran verringert werden soll. Eine geringere Auslenkung des piezoelektrischen Aktors entspricht dabei einer geringeren Auslenkung der Membran. Die durch das Entladen freiwerdende elektrische Energie kann dabei wieder in der Energiequelle gespeichert werden.

Außerdem weist die Vorrichtung eine einen Regelkreis ausbildende Rückkopplung auf, mit der die Spannung des piezoelektrischen Aktors als Rückführsignal rückkoppelbar ist, wobei das Rückführsignal im bestimmungsgemäßen Gebrauch im hörbaren Frequenzbereich ein von der Korrektureinheit, dem PWM-Generator, der Leistungsstufe und/oder dem piezoelektrischen Lautsprecher verursachtes erstes Signalrauschen aufweist. Die Rückkopplung schließt somit den Regelkreis, so dass die Tonqualität des Lautsprechers verbessert werden kann. Die Rückkopplung kann beispielsweise das Rückführsignal, insbesondere in Signalflussrichtung, vor die digitale Korrektureinheit rückkoppeln.

Das erste Signalrauschen führt zu einer verminderten Tonqualität des piezoelektrischen Lautsprechers. Das erste Signalrauschen kann beispielsweise eine Ursache darin haben, dass vom Signaleingang, über die Korrektureinheit, über den PWM-Generator, über die Leistungsstufe und zum piezoelektrischen Aktor das digitale Audiosignal in eine analoge Spannung für den piezoelektrischen Aktor umgewandelt wird. Dies kann jedoch lediglich mit einer endlichen Genauigkeit ausgeführt werden, da beispielsweise der PWM-Generator das von der Korrektureinheit korrigierte Signal mit einer Ungenauigkeit in das Schaltsignal umwandeln kann. Der PWM-Generator kann beispielsweise ein Quantisierungsrauschen aufweisen. Zusätzlich oder alternativ kann auch die Korrektureinheit, die Leistungsstufe und/oder der piezoelektrische Lautsprecher das Quantisierungsrauschen aufweisen. Die Genauigkeit der Korrektureinheit, des PWM-Generators und/oder Leistungsstufe kann beispielsweise lediglich 8 Bit betragen, was zum einen dazu führt, dass die Vorrichtung kompakt ausgebildet werden kann. Andererseits kann eine derartige Auflösung zu den genannten Quantisierungsfehlern bzw. zum Quantisierungsrauschen führen. Zusätzlich dazu reduziert die Nichtlinearität die Qualität des Audiosignals und/oder des vom Lautsprecher erzeugten Schalls.

Erfindungsgemäß weist die Vorrichtung eine Rauschformungseinheit auf, die derart ausgebildet und/oder derart in den Regelkreis implementiert ist, dass mittels dieser eine Rauschenergie des ersten Signalrauschens der Korrektureinheit, dem PWM-Generator, der Leistungsstufe und/oder dem piezoelektrischen Lautsprecher außerhalb des hörbaren Frequenzbereichs verschiebbar ist. Außerhalb des hörbaren Frequenzbereichs kann der Mensch das erste Signalrauschen nicht mehr wahrnehmen, so dass die Tonqualität des Lautsprechers verbessert ist.

Die Rauschenergie des ersten Signalrauschens ist mittels der Rauschformungseinheit in einen Hochfrequenzbereich verschiebbar. Der Hochfrequenzbereich kann beispielsweise oberhalb von 20 kHz liegen, bei dem der Mensch das erste Signalrauschen nicht mehr wahrnehmen kann. Zusätzlich oder alternativ kann die Rauschformungseinheit die Rauschenergie des ersten Signalrauschens auch in den Bereich einer Systemabtastfrequenz der Vorrichtung verschieben. Die Systemabtastfrequenz kann beispielsweise im Bereich von 1 MHz liegen. Die Systemabtastfrequenz kann dabei die Arbeitsfrequenz der Vorrichtung sein. D.h. die Systemabtastfrequenz kann die Frequenz sein, mit der die Vorrichtung arbeitet, insbesondere mit welchem Takt die Vorrichtung beispielsweise das Audiosignal verarbeitet.

Dadurch kann die Tonqualität verbessert werden. Wenn die Rauschenergie in einen hohen Frequenzbereich verschoben wird, schwächt der piezoelektrische Aktor derartige Frequenzen auch selbst ab. Da der piezoelektrische Aktor eine gewisse Masse aufweist, weist er eine entsprechende Trägheit auf. Der piezoelektrische Aktor kann hohen Frequenzen nicht mehr folgen, so dass diese hohen Frequenzen vom piezoelektrischen Aktor selbst gedämpft werden. Der piezoelektrische Aktor kann selbst als Tiefpass wirken.

Von Vorteil ist es, wenn die Vorrichtung als Regelkreisschaltung ausgebildet ist. Die Regelkreisschaltung kann computerimplementiert sein. Die Regelkreisschaltung kann dann von einem Computerprogramm ausgeführt werden. Zusätzlich oder alternativ kann die Regelkreisschaltung auch eine elektronische Regelkreisschaltung sein, so dass die Regelkreisschaltung beispielsweise in einem ASIC angeordnet ist.

Zusätzlich oder alternativ kann der Regelkreis auch einen Vorwärtspfad aufweisen. Der Vorwärtspfad kann beispielsweise den Signaleingang, die digitale Korrektureinheit, den PWM-Generator, die Leistungsstufe und/oder die piezoelektrischen Lautsprecher umfassen. Diese können in der hier genannten Richtung in der Signalflussrichtung eines Signalflusses angeordnet sein.

Zusätzlich oder alternativ kann der Regelkreis zumindest einen Rückkopplungspfad aufweisen. Der Rückkopplungspfad kann das Rückführsignal, welches die Spannung des piezoelektrischen Aktors umfassen kann, rückkoppeln, so dass der Regelkreis geschlossen ist.

Vorteilhaft ist es, wenn die Rauschformungseinheit in Signalflussrichtung der Korrektureinheit vorgelagert ist. Dadurch erhält die Korrektureinheit das von der Rauschformungseinheit geformte Signal, in dem die Rauschenergie außerhalb des hörbaren Wellenlängenspektrums verschoben ist. Die Rauschformungseinheit kann dabei beispielsweise im Vorwärtspfad in Signalflussrichtung der Korrektureinheit vorgelagert sein.

Von Vorteil ist es, wenn die Rauschformungseinheit einen Rauschformungsblock zum Verschieben der Rauschenergie des ersten Signalrauschens aufweist. Der Rauschformungsblock kann darauf optimiert sein, die Rauschenergie des ersten Signalrauschens außerhalb des hörbaren Wellenlängenspektrums zu verschieben.

Zusätzlich oder alternativ kann die Rauschformungseinheit einen Schleifenfilter zur Unterdrückung des Quantisierungsrauschens und/oder eine noch vorhandene Nichtlinearität nach der Korrektureinheit und/oder des PWM-Generators aufweisen, so dass die Tonqualität verbessert werden kann.

Vorteilhaft ist es, wenn der Schleifenfilter dem Rauschformungsblock in Signalflussrichtung nachgelagert ist. Zusätzlich oder alternativ kann der Schleifenfilter in Signalflussrichtung der Korrektureinheit vorgelagert sein.

Von Vorteil ist es, wenn die Vorrichtung einen Analog/Digital-Wandler aufweist, mittels dem das Rückführsignal digitalisierbar ist, wobei das umgewandelte digitale Rückführsignal im bestimmungsgemäßen Gebrauch ein von dem Analog/Digital-Wandler verursachtes zweites Signalrauschen aufweist. Der Analog/Digital-Wandler wird auch als A/D-Wandler abgekürzt, wobei hier ebenfalls auf diese Abkürzung zurückgegriffen wird. Mittels des A/D-Wandlers kann das Rückführsignal digitalisiert werden, so dass es in einem elektronischen und/oder logischen Schaltkreis verarbeitet werden kann. Da jeder A/D-Wandler eine endliche Auflösung aufweist, entstehen beim Digitalisieren ebenfalls Fehler, insbesondere Quantisierungsfehler bzw. Quantisierungsrauschen. Der A/D-Wandler erzeugt somit das zweite Signalrauschen.

Vorteilhaft ist es, wenn der A/D-Wandler im Rückkopplungspfad angeordnet ist. Der A/D-Wandler ist in Signalflussrichtung dem piezoelektrischen Lautsprecher nachgeordnet.

Von Vorteil ist es, wenn der Rauschformungsblock derart ausgebildet ist, dass dieser nur das erste Signalrauschen verarbeitet. Der Rauschformungsblock verarbeitet somit nicht das zweite Signalrauschen. Beispielsweise kann das erste Signalrauschen größer sein als das zweite Signalrauschen, so dass es effektiver ist, lediglich das erste Signalrauschen zu verarbeiten. Das zweite Signalrauschen kann auch dadurch verringert und somit vernachlässigt werden, wenn der A/D-Wandler eine entsprechend hohe Auflösung aufweist. Der A/D-Wandler kann beispielsweise eine Auflösung von 12, 14 oder 16 Bit aufweisen.

Die Rauschformungseinheit umfasst eine Signal-Übertragungsfunktion, mittels der anhand einer Regelabweichung zwischen dem digitalen Audiosignal und dem digitalen Rückführsignal eine Stellgröße zum Ansteuern des Lautsprechers bestimmbar ist. Die Stellgröße kann eine Spannung zum Ansteuern des Lautsprechers sein. Die Stellgröße kann auch eine Spannungsdifferenz sein, mit der der piezoelektrische Lautsprecher geladen oder entladen wird. Die Regelabweichung gibt die Abweichung an, die zwischen einem Ist-wert der Spannung des piezoelektrischen Aktors, nämlich dem digitalen Rückführsignal, und dem Sollwert des piezoelektrischen Aktors, welche vom digitalen Audiosignal abhängig ist, besteht. Ist die Regelabweichung Null, weist der piezoelektrische Aktor die Spannung auf, die dieser gemäß dem digitalen Audiosignal haben soll. Der piezoelektrische Aktor gibt somit das Audiosignal ohne Fehler aus. Jedoch weist der piezoelektrische Aktor das erste und/oder zweite Signalrauschen auf. Insbesondere das erste Signalrauschen führt zu einem Fehler, der durch die Regelabweichung bestimmt werden kann. Die Regelabweichung kann beispielsweise als Differenz zwischen dem digitalen Audiosignal und dem digitalen Rückführsignal gebildet werden. Mit Hilfe der Signal-Übertragungsfunktion kann daraus die Stellgröße zum Ansteuern des Lautsprechers bestimmt werden, so dass der Fehler vermindert wird. Die Stellgröße kann dabei eine Spannung sein. Die Regelabweichung ist dabei das Eingangssignal und die Stellgröße das Ausgangssignal.

Vorteilhaft ist es, wenn die Signal-Übertragungsfunktion derart ausgebildet ist, dass mittels dieser die Regelabweichung um eine Periode verzögerbar ist. Bei der Periode kann es sich vorteilhafterweise um eine Periode der Systemabtastfrequenz bzw. der Arbeitsfrequenz der Vorrichtung handeln. Dadurch erfolgt die Regelung für jeweils die, beispielsweise auf die Rückkopplung des Rückführsignals, darauffolgende Periode.

Von Vorteil ist es, wenn die Signal-Übertragungsfunktion $STF_d$ durch folgende erste Formel definiert ist:

$$STF_d = \frac{X}{d} = \frac{H(z)}{[1 + I(z) * (1 + K(z))H(z)]}$$

wobei $H(z)$ die Systemfunktion, $I(z)$ die Lautsprecherfunktion, $K(z)$ die Umkehrfunktion von $I(z)$, $d$ die Regelabweichung und $X$ die Stellgröße für den Lautsprecher ist. Die Signal-Übertragungsfunktion definiert sich durch $d$ als Eingangsgröße bzw. -signal und $X$ als Ausgangsgröße bzw. -signal. Für eine Systemfunktion $H(z)$ kann die Signal-Übertragungsfunktion $STF_d$ beispielsweise $z^{-1}$ sein. Für andere Systemfunktionen $H(z)$ kann die Signal-Übertragungsfunktion $STF_d$ je nach Anforderung anders aussehen. Die Signal-Übertragungsfunktion $STF_d$ kann beispielsweise auch höhere Ordnungen aufweisen.

Vorteilhaft ist es, wenn die Rauschformungseinheit eine Rauschformungs-Übertragungsfunktion umfasst, mittels der die Rauschenergie des ersten Signalrauschens verschiebbar ist. Die Rauschformungs-Übertragungsfunktion kann dabei derart ausgebildet sein, dass diese die Rauschenergie des ersten Signalrauschens in das nicht hörbare Wellenlängenspektrum, insbesondere zu Frequenzen über 20 kHz, vorzugsweise in einen Bereich der Systemabtastfrequenz, verschiebt.

Von Vorteil ist es, wenn die Rauschformungs-Übertragungsfunktion derart ausgebildet ist, dass mittels dieser niedrige Frequenzen gedämpft werden. Insbesondere wird dieser Frequenzbereich gedämpft, der die Rauschenergie des ersten Signalrauschens aufweist, so dass die Tonqualität verbessert wird.

Vorteilhaft ist es, wenn die Rauschformungs-Übertragungsfunktion $NTF_d$ durch folgende zweite Formel definiert ist:

$$NTF_d = \frac{X}{Q_z} = \frac{1}{[1 + I(z) * (1 + K(z))H(z)]}$$

wobei $H(z)$ die Systemfunktion, $I(z)$ die Lautsprecherfunktion, $K(z)$ die Umkehrfunktion von $I(z)$, $d$ die Regelabweichung und $X$ die Stellgröße für den Lautsprecher ist. $Q(z)$ kann die Störgröße der digitalen Korrektureinheit, des PWM-Generators, der Leistungsstufe und/oder dem piezoelektrischen Lautsprechers sein. Dabei beschreibt $Q(z)$ beispielsweise den Quantisierungsfehler, welcher durch den PWM-Generator entsteht. Mittels $Q(z)$ kann beispielsweise das erste Signalrauschen definiert werden. $Q(z)$ kann beispielsweise alle Fehler umfassen, die bei der Verarbeitung des digitalen Audiosignals bis zur Ansteuerung, beispielsweise eines Ausgabesignals, des piezoelektrischen Aktors entstehen. $Q(z)$ kann das erste Signalrauschen umfassen. $Q(z)$ entspricht in der Rauschformungs-Übertragungsfunktion dem Eingangssignal und $X$ dem Ausgangssignal. Für eine Systemfunktion $H(z)$ kann die Rauschformungs-Übertragungsfunktion $NTF_d$ beispielsweise $1 - z^{-1}$ sein. Für andere Systemfunktionen $H(z)$ kann die Rauschformungs-Übertragungsfunktion $NTF_d$ je nach Anforderung anders aussehen. Die Rauschformungs-Übertragungsfunktion $NTF_d$ kann beispielsweise auch höhere Ordnungen aufweisen.

Von Vorteil ist es, wenn eine Stellgrößen-Übertragungsfunktion durch folgende dritte Formel definiert ist:

$$X(z) = d * STF_d + Q_z * NTF_d$$

Diese dritte Formel umfasst als $STF_d$ die Signal-Übertragungsfunktion und mit $NTF_d$ die Rauschformungs-Übertragungsfunktion, $d$ entspricht der Regelabweichung und $Q(z)$ das erste Signalrauschen bzw. die Quantisierungsfehler. Für eine Systemfunktion $H(z)$ kann $X(z) = z^{-1}*d + Q_z*(1 - z^{-1})$ sein. Für andere Systemfunktion $H(z)$ kann der Ausdruck für $X(z)$ je nach Anforderung anders sein.

Vorteilhaft ist es, wenn eine Regelgrößen-Übertragungsfunktion durch folgende vierte Formel definiert ist:

$$Y(Z) = V_{in} \frac{STF_d * I(z)}{(1 + STF_d * I(z))} + Q_z \frac{NTF_d * I(z)}{(1 + NTF_d * I(z))}$$

Darin ist $V_{in}$ das digitale Audiosignal. Für eine Systemfunktion $H(z)$ kann $Y(z) = z^{-1}*V_{in} + Q_z*(1 - z^{-1})$ sein. Für andere Systemfunktion $H(z)$ kann der Ausdruck für $Y(z)$ je nach Anforderung anders sein.

Von Vorteil ist es, wenn die Rauschformungseinheit derart ausgebildet ist, dass mittels dieser Nullstellen, Polstellen und/oder die Ordnung zumindest einer Übertragungsfunktion derart bestimmbar ist, dass ein Signal-Rauschverhältnis erhöht wird. Zusätzlich oder alternativ die Rauschformungseinheit derart ausgebildet ist, dass mittels dieser Nullstellen, Polstellen und/oder die Ordnung zumindest einer Übertragungsfunktion derart bestimmbar ist, dass eine harmonische Verzerrung reduziert wird. Dadurch wird die Tonqualität verbessert.

Vorteilhaft ist es, wenn die Vorrichtung eine Rechen-Steuereinheit umfasst, in der die Signal-Übertragungsfunktion, die Rauschformungs-Übertragungsfunktion, die Stellgrößen-Übertragungsfunktion und/oder die Regelgrößen-Übertragungsfunktion implementiert sind. Die Vorrichtung kann auch einen Mikrokontroller aufweisen, in der die Signal-Übertragungsfunktion, die Rauschformungs-Übertragungsfunktion, die Stellgrößen-Übertragungsfunktion und/oder die Regelgrößen-Übertragungsfunktion implementiert sind.

Von Vorteil ist es, wenn in der digitalen Korrektureinheit Messdaten eines standardisierten piezoelektrischen Lautsprechers abgespeichert sind, die dessen nichtlineares Verhalten wiedergeben. Die Messdaten können beispielsweise in einer Tabelle hinterlegt sein. Ferner können die Messdaten beispielsweise die Kapazität des piezoelektrischen Lautsprechers umfassen, welche vorzugsweise in Abhängigkeit der Aufladung des piezoelektrischen Lautsprechers abgespeichert ist. Die Messdaten können dabei die Daten enthalten, die das Verhalten des piezoelektrischen Lautsprechers charakterisieren. Die Messdaten können aber auch Werte zur Korrektureinheit, zum PWM-Generator und/oder zur Leistungsstufe umfassen. Die Messdaten können beispielsweise Werte zu Kapazitäten, Induktivitäten und/oder Kennlinien umfassen. Damit kann beispielsweise ermittelt werden, wie lange der piezoelektrische Lautsprecher bzw. der piezoelektrische Aktor aufgeladen werden muss, um eine bestimmte, zu einem Audiosignal entsprechende, Auslenkung der Membran des piezoelektrischen Lautsprechers zu erhalten. Die Messdaten können Systemparameter der Vorrichtung umfassen.

Des Weiteren ist es vorteilhaft, wenn mittels der Korrektureinheit unter Berücksichtigung dieser Messdaten zumindest ein Teil der Nichtlinearitäten des Lautsprechers korrigierbar sind. Dadurch wird die Tonqualität des piezoelektrischen Lautsprechers verbessert.

Vorgeschlagen wird außerdem ein Verfahren zur Audiosignalverarbeitung für einen piezoelektrischen Lautsprecher zum Erzeugen von Schallwellen im hörbaren Wellenlängenspektrum. Dabei kann mit Hilfe des Verfahrens die Vorrichtung betrieben werden, die gemäß einem oder mehreren Merkmalen der vorangegangenen und/oder nachfolgenden Beschreibung ausgebildet ist.

Beim Verfahren wird ein über einen Signaleingang eingespeistes digitales Audiosignal verarbeitet. Anhand des digitalen Audiosignals wird der Schall durch den Lautsprecher erzeugt. Das digitale Audiosignal umfasst Informationen über Musik, Töne und/oder Sprache, die durch den Lautsprecher wiedergegeben werden sollen. Das Verfahren bearbeitet das digitale Audiosignal, so dass der Lautsprecher die im Audiosignal gespeicherten Informationen zur Musik, zu den Tönen und/oder zur Sprache in den entsprechenden Schall umsetzen kann.

Beim Verfahren wird eine Nichtlinearität des Lautsprechers von einer digitalen Korrektureinheit korrigiert. Da der Lautsprecher nicht linear auf das Audiosignal reagieren kann, werden die Nichtlinearitäten mit Hilfe der Korrektureinheit korrigiert. Diese können beispielsweise ihren Grund darin haben, dass der Lautsprecher bei verschiedenen Zuständen unterschiedlich reagiert. Beispielsweise weist der piezoelektrische Lautsprecher eine Kapazität auf, die von dem aktuellen Ladezustand des piezoelektrischen Lautsprechers abhängt. Die Korrektureinheit kann beispielsweise den aktuellen Zustand, beispielsweise den Ladezustand, des piezoelektrischen Lautsprechers mit einberechnen, um die Nichtlinearitäten zu korrigieren. Außerdem kann die Temperatur des piezoelektrischen Lautsprechers zu den Nichtlinearitäten führen. Unterschiedliche Temperaturen können zu unterschiedlichem Verhalten führen. Des Weiteren kann auch das Alter des piezoelektrischen Lautsprechers zu den Nichtlinearitäten führen. Ein älterer Lautsprecher kann auf ein Signal anders reagieren als ein neuerer Lautsprecher.

Ferner wird das von der Korrektureinheit korrigierte Signal von einem digitalen PWM-Generator in ein pulsweitenmoduliertes Schaltsignal umgewandelt.

Eine Leistungsstufe wird mit dem vom PWM-Generator umgewandelte Schaltsignal derart angesteuert, dass ein piezoelektrischer Aktor des Lautsprechers zum Auslenken einer Membran mit einer Spannung aufgeladen wird. Wird die Membran ausgelenkt, wird die über der Membran angeordnete Luft in Schwingung versetzt, was den Schallwellen entspricht, die die Töne, die Musik und/oder die Sprache übertragen. Infolgedessen ist das korrekte Auslenken der Membran wichtig. Ein nicht korrektes Auslenken der Membran führt zu Schallwellen, die verzerrte bzw. fehlerhafte Sprache, Töne und/oder Sprache übertragen. Um eine hohe Tonqualität erreichen zu können ist es vorteilhaft, dass die Auslenkung so gut wie möglich dem digitalen Audiosignal entspricht.

Die Membran kann dabei schrittweise ausgelenkt werden, wenn der piezoelektrische Aktor schrittweise aufgeladen wird. Die kann beispielsweise dann durchgeführt werden, wenn eine Energiequelle, beispielsweise eine Batterie, eine Versorgungsspannung von 3V aufweist, der piezoelektrische Aktor jedoch mit bis zu 30V ausgeladen wird.

Die Leistungsstufe kann beispielsweise zumindest einen Schalter umfassen, der vom pulsweitenmoduliertes Schaltsignal des PWM-Generators angesteuert wird. Der piezoelektrische Aktor wird dadurch mit einer Spannung aufgeladen, die einen analogen Wert aufweisen kann. Die Korrektureinheit, der PWM-Generator und/oder die Leistungsstufe können somit das digitale Audiosignal in eine Spannung des piezoelektrischen Aktors umwandeln, wobei die Spannung einen analogen Wert aufweist. Die Korrektureinheit, der PWM-Generator und/oder Leistungsstufe können somit als ein Digital-/Analog-Wandler sein.

Ferner wird die Spannung des piezoelektrischen Aktors über eine Rückkopplung eines Regelkreises als Rückführsignal rückgekoppelt. Dabei weist das Rückführsignal im bestimmungsgemäßen Gebrauch im hörbaren Frequenzbereich ein von der Korrektureinheit, dem PWM-Generator, der Leistungsstufe und/oder dem piezoelektrischen Lautsprecher verursachtes erstes Signalrauschen auf. Die Rückkopplung schließt somit den Regelkreis. Mit Hilfe des Regelkreises wird eine Tonqualität des piezoelektrischen Lautsprechers verbessert. Beispielsweise können mit Hilfe des Regelkreises Fehler im ausgegebenen Schall vermindert werden, die beispielsweise durch Fehler in der Signalverarbeitung der Korrektureinheit, des PWM-Generators, des piezoelektrischen Lautsprechers und/oder der Leistungsstufe entstehen.

Erfindungsgemäß wird mit einer Rauschformungseinheit eine Rauschenergie des ersten Signalrauschens der Korrektureinheit, des PWM-Generators, der Leistungsstufe und/oder des piezoelektrischen Lautsprechers aus dem hörbaren Frequenzbereich verschoben. Die Rauschenergie wird dabei in einen Bereich verschoben, der oberhalb des hörbaren Frequenzbereichs liegt. Beispielsweise kann die Rauschenergie über eine Frequenz von 20 kHz verschoben werden. In einem derartigen Frequenzbereich kann das menschliche Gehör das erste Signalrauschen nicht mehr wahrnehmen, so dass die Tonqualität des durch den Lautsprecher ausgegebenen Schalls verbessert wird. Alternativ kann die Rauschenergie auch in einen Bereich der Systemabtastfrequenz verschoben werden. Die Systemabtastfrequenz kann auch die Arbeitsfrequenz des Verfahrens zur Audiosignalverarbeitung sein und beispielsweise in einem Bereich von 1 MHz liegen. In einem derartigen Frequenzbereich weist der piezoelektrische Aktor bzw. Lautsprecher eine Trägheit auf, so dass der piezoelektrische Aktor bzw. Lautsprecher dieser Frequenz nicht mehr folgen kann. Dadurch wird die Rauschenergie des ersten Signalrauschens gedämpft. Der piezoelektrische Aktor bzw. Lautsprecher weisen Eigenschaften eines Tiefpasses auf.

Weitere Vorteile der Erfindung sind in den nachfolgenden Ausführungsbeispielen beschrieben. Es zeigen:

Figur 1   ein Blockschaltbild einer Vorrichtung zur Audiosignalverarbeitung für einen piezoelektrischen Lautsprecher,

Figur 2   ein Blockschaltbild einer Vorrichtung zur Audiosignalverarbeitung für einen piezoelektrischen Lautsprecher mit einer Rauschformungseinheit und

Figur 3   ein Flussdiagramm eines linearen Modells der Signalverarbeitung für einen piezoelektrischen Lautsprecher.

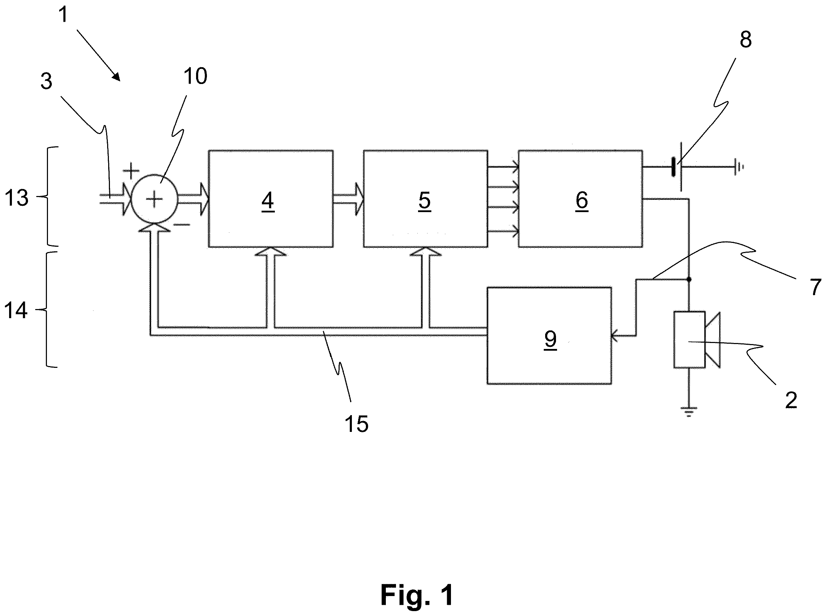

Figur 1 zeigt ein Blockschaltbild einer Vorrichtung 1 zur Audiosignalverarbeitung für einen piezoelektrischen Lautsprecher 2. Mittels des piezoelektrischen Lautsprechers 2 können Schallwellen im hörbaren Wellenlängenspektrum erzeugt werden, welche vom menschliche Gehör wahrgenommen werden können. Die Schallwellen können Töne, Musik und/oder Sprache umfassen, so dass mit Hilfe des Lautsprechers 2 beispielsweise Musik gehört oder telefoniert werden kann. Die Vorrichtung 1 und der Lautsprecher 2 können somit beispielsweise in einem Smartphone, einem MP3-Player oder einem sonstigen, insbesondere tragbaren, Gerät angeordnet sein.

Der piezoelektrische Lautsprecher 2 umfasst einen hier nicht gezeigten piezoelektrischen Aktor, mit dem eine ebenfalls nicht gezeigte Membran des Lautsprechers 2 ausgelenkt werden kann, um über der Membran angeordnete Luft in Schwingung zu versetzen, so dass die Schallwellen erzeugt werden, die die Töne, die Musik und/oder die Sprache transportieren.

Um den piezoelektrischen Aktor auszulenken, kann dieser mit einer elektrischen Spannung aufgeladen werden. Steigt bzw. sinkt die elektrische Spannung des piezoelektrischen Aktors, vergrößert bzw. verringert sich auch seine eigene Auslenkung. Durch die Aufladung des piezoelektrischen Aktors kann auf ihm elektrische Energie gespeichert werden, so dass der Aktor Eigenschaften eines Kondensators aufweist und eine Kapazität besitzt.

Die Vorrichtung 1 weist ferner einen Signaleingang 3 für ein digitales Audiosignal auf. Das digitale Audiosignal umfasst akustische Informationen entsprechend der Musik, den Tönen und/oder der Sprache, welche durch den Lautsprecher 2 erzeugt werden sollen. Im Allgemeinen umfasst das Audiosignal Informationen über die Schallwellen, die der Lautsprecher 2 erzeugen soll. Eine Qualität der vom Lautsprecher 2 erzeugten Schallwellen, insbesondere eine Tonqualität, kann davon abhängen, dass die Vorrichtung 1 den piezoelektrischen Aktor passend zum digitalen Audiosignal auslenkt.

Die Vorrichtung 1 weist, gemäß dem vorliegenden Beispiel, eine digitale Korrektureinheit 4 auf, mittels der Nichtlinearitäten des piezoelektrischen Lautsprechers 2 korrigierbar sind. Nichtlinearitäten können beispielsweise dadurch auftreten, dass eine Änderung der Auslenkung des piezoelektrischen Aktors von der momentanen Auslenkung des piezoelektrischen Aktors selbst abhängt. Ferner kann die Kapazität des piezoelektrischen Aktors von der Auslenkung abhängen, so dass dies ebenfalls eine Quelle der Nichtlinearitäten ist. Bei der Ermittlung der Spannung, mit der der piezoelektrische Aktor aufgeladen wird, muss beispielsweise auch die gegenwärtige Spannung mit berücksichtigt werden. Die Nichtlinearitäten können dabei noch mehrere Ursachen haben. So kann auch eine Größe, die Temperatur oder ein Alter des piezoelektrischen Aktors berücksichtigt werden. Zusätzlich oder alternativ kann aber die Vorrichtung 1 selbst auch zu Nichtlinearitäten des Lautsprechers 2 führen.

Die digitale Korrektureinheit 4 kann das digitale Audiosignal erhalten und ein korrigiertes Signal ausgeben.

Die Vorrichtung 1 umfasst ferner einen PWM-Generator 5, mit dem das von der Korrektureinheit 4 korrigierte Signal in ein pulsweitenmoduliertes Schaltsignal umwandelbar ist.

Des Weiteren umfasst die Vorrichtung 1 eine Leistungsstufe 6, die mit dem vom PWM-Generator 5 umgewandelten Schaltsignal derart ansteuerbar ist, dass der piezoelektrische Aktor des piezoelektrischen Lautsprechers 2 zum Auslenken der Membran mit einer Spannung aufladbar ist. Die Leistungsstufe 6 kann beispielsweise eine Verstärkereinheit sein, welche beispielsweise eine Spannung von 3V auf 30V erhöht. Die Leistungsstufe 6 kann das pulsweitenmodulierte Schaltsignal derart verarbeiten, dass der piezoelektrische Aktor des Lautsprechers 2 mit der Spannung aufgeladen wird. Dabei hängt die Spannung, mit der der piezoelektrische Aktor aufgeladen wird, von dem pulsweitenmodulierten Schaltsignal ab. Über das pulsweitenmodulierte Schaltsignal kann die Spannung des Aktors eingestellt werden. Dabei wird die Spannung derart eingestellt, dass der piezoelektrische Aktor derart aufgeladen wird, dass die Membran derart ausgelenkt wird, dass ein zum digitalen Audiosignal passender Schall erzeugt wird.

Die Leistungsstufe 6 kann dabei von einer Energieversorgung 8 mit elektrischer Energie versorgt werden, um den piezoelektrischen Aktor bzw. den piezoelektrischen Lautsprecher 2 aufzuladen. Die Energieversorgung 8 kann beispielsweise eine Batterie des Smartphones sein.

Um einen Regelkreis auszubilden, weist die Vorrichtung 1 eine Rückkopplung 7 auf, mit der die Spannung des piezoelektrischen Aktors als Rückführsignal rückkoppelbar ist.

Die Rückkopplung 7 kann zu einer ersten Additionsstelle 10 zurückgekoppelt werden. Die erste Additionsstelle 10 kann derart ausgebildet sein, dass diese das Rückführsignal mit dem digitalen Audiosignal vergleicht. Die erste Additionsstelle 10 kann beispielsweise eine Differenz zwischen dem Rückführsignal und dem digitalen Audiosignal bilden. Da die erste Additionsstelle 10 eine Differenz bildet, kann diese auch eine Subtraktionsstelle sein. Dadurch kann ein Fehler bzw. eine Abweichung zwischen dem Audiosignal und der Spannung am piezoelektrischen Aktor ermittelt werden, was einer Abweichung zwischen dem Soll-Wert, welcher das digitale Audiosignal darstellt, und dem Ist-Wert, welcher der Spannung am piezoelektrischen Aktor darstellt, entspricht.

Bevor das Rückführsignal zur ersten Additionsstelle 10 rückgekoppelt wird, kann es einem Analog/Digital-Wandler 9 (kurz A/D-Wandler) zugeführt werden. Durch den A/D-Wandler 9 kann das Rückführsignal digitalisiert werden, um es in einem elektronischen bzw. logischen Schaltkreis verarbeiten zu können.

Das Rückführsignal weist im bestimmungsgemäßen Gebrauch im hörbaren Frequenzbereich der durch den piezoelektrischen Lautsprecher 2 erzeugten Schallwellen ein von der Korrektureinheit 4, dem PWM-Generator 5, der Leistungsstufe 6 und/oder dem piezoelektrischen Lautsprecher 2 verursachtes erstes Signalrauschen auf.

Das erste Signalrauschen kann beispielsweise durch ein Quantisierungsrauschen bzw. Quantisierungsfehler entstehen. Die Korrektureinheit 4, der PWM-Generator 5, die Leistungsstufe 6 und/oder der piezoelektrische Lautsprecher 2 können als Digital-/Analog-Wandler (oder kurz D/A-Wandler) beschrieben werden, da diese ein digitales Audiosignal am Signaleingang 3 zu einer Spannung des piezoelektrischen Aktors umwandeln, wobei diese Spannung analog ist. Dabei können die Korrektureinheit 4, der PWM-Generator 5 und die Leistungsstufe 6 als D/A-Wandler zusammengefasst werden, da diese das digitale Audiosignal in ein Ausgabesignal für den piezoelektrischen Lautsprecher 2 umsetzen. Durch die Umwandlung vom digitalen Audiosignal in die Spannung des Aktors bzw. des Ausgabesignals für den Lautsprecher 2 können die Quantisierungsfehler auftreten, die zum ersten Signalrauschen führen, was zu einer verminderten Tonqualität im hörbaren Frequenzbereich führen kann.

Die Vorrichtung 1 weist ferner einen Vorwärtspfad 13 auf. Der Vorwärtspfad 13 umfasst in der vorliegenden Ausführung den Signaleingang 3, die digitale Korrektureinheit 4, den PWM-Generator 5 und die Leistungsstufe 6 auf. Zusätzlich weist der Vorwärtspfad 13 noch den piezoelektrischen Lautsprecher 2 auf, obwohl er in Figur 1 nicht in einer Linie mit den anderen Elementen des Vorwärtspfads 13 angeordnet ist. Die Energieversorgung 8 kann ebenfalls Teil des Vorwärtspfads 13 sein.

Die Vorrichtung 1 weist zusätzlich oder alternativ einen Rückkopplungspfad 14 auf. Der Rückkopplungspfad 14 weist hier den A/D-Wandler 9 auf, der das Rückführsignal vom piezoelektrischen Lautsprecher 2 erhält, digitalisiert und rückkoppelt.

Der Vorwärtspfad 13 und der Rückkopplungspfad 14 können den Regelkreis bilden.

Die Vorrichtung 1 bzw. der Regelkreis weist ferner einen Signalfluss 15 auf, wobei die Signalflussrichtung durch die Pfeile in den Figuren gekennzeichnet ist. Der Signalfluss 15 führt beispielsweise vom Signaleingang 3 über die erste Additionsstelle 10, über die Korrektureinheit 4, über den PWM-Generator 5, über die Leistungsstufe 6 zum piezoelektrischen Lautsprecher 2, wobei dies den Vorwärtspfad 13 bilden kann. Der Signalfluss 15 führt ferner vom piezoelektrischen Lautsprecher 2, über den A/D-Wandler 9 zurück zum Signaleingang 3 bzw. zur ersten Additionsstelle 10, wobei dies den Rückkopplungspfad 14 bilden kann. Der Signalfluss 15 ist somit im Regelkreis geführt.

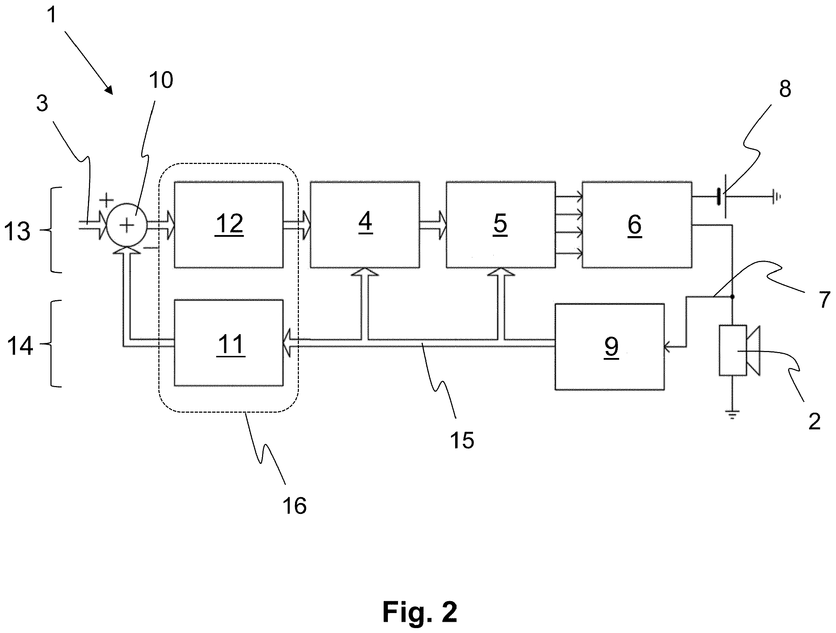

Figur 2 zeigt ein Blockschaltbild einer Vorrichtung 1 zur Audiosignalverarbeitung für den piezoelektrischen Lautsprecher 2. Die Vorrichtung 1 weist eine Rauschformungseinheit 16 auf, die derart ausgebildet ist, dass mittels dieser die Rauschenergie des ersten Signalrauschens der Korrektureinheit 4, des PWM-Generators 5, der Leistungsstufe 6 und/oder des piezoelektrischen Lautsprechers 2 außerhalb des hörbaren Frequenzbereichs verschiebbar ist. Beispielsweise kann die Rauschenergie des ersten Signalrauschens in einen Bereich oberhalb des hörbaren Frequenzbereichs verschoben werden. Der hörbare Frequenzbereich endet bei etwa 20 kHz, so dass die Rauschenergie des ersten Signalrauschens, wenn diese dorthin verschoben wird, nicht mehr vom menschlichen Gehör wahrgenommen werden kann. Beispielsweise kann die Rauschenergie in einen Frequenzbereich verschoben werden, der höher als 20 kHz oder höher als 100 kHz liegt.

Die Rauschenergie des ersten Signalrauschens kann dabei auch in einen Frequenzbereich einer Systemabtastfrequenz der Vorrichtung 1 verschoben werden. Die Systemabtastfrequenz kann beispielsweise die Arbeitsfrequenz der Vorrichtung 1 sein. Diese kann beispielsweise im Bereich von 1 MHz liegen. Bei derart hohen Frequenzen kann die Rauschenergie des ersten Signalrauschens auch gedämpft werden, da der piezoelektrische Aktor derart hohen Frequenzen nicht folgen kann. Der piezoelektrische Aktor kann infolgedessen Eigenschaften eines Tiefpasses aufweisen.

Die Rauschformungseinheit 16 kann gemäß dem vorliegenden Ausführungsbeispiel in Signalflussrichtung des Signalflusses 15 der Korrektureinheit 4 vorgelagert sein. Beispielsweise kann die Rauschformungseinheit 16 im Vorwärtspfad 13 und/oder im Rückkopplungspfad 14 angeordnet sein. Ferner ist die Rauschformungseinheit 16 in Signalflussrichtung des Signalflusses 15 dem A/D-Wandler 9 nachgeordnet.

Des Weiteren kann die Rauschformungseinheit 16 gemäß dem vorliegenden Ausführungsbeispiel einen Rauschformungsblock 11 und/oder einen, insbesondere digitalen, Schleifenfilter 12 aufweisen. Mit Hilfe des Rauschformungsblocks 11 kann die Rauschenergie des ersten Signalrauschens nach außerhalb des hörbaren Frequenzbereichs verschoben werden. Der Rauschformungsblock 11 ist hier im Rückkopplungspfad 14 angeordnet. Ferner ist der Rauschformungsblock 11 in Signalflussrichtung des Signalflusses 15 dem A/D-Wandler 9 nachgeordnet. Der Rauschformungsblock 11 ist in Signalflussrichtung des Signalflusses 15 dem Signaleingang 3 vorgelagert. Der Rauschformungsblock 11 verschiebt in einem Verfahren somit die Rauschenergie nach außerhalb des hörbaren Frequenzbereichs. Das durch den Rauschformungsblock 11 und/oder die Rauschformungseinheit 16 geformte Signal wird dann beim Verfahren der ersten Additionsstelle 10 zugeführt.

Der Schleifenfilter 12 ist hier im Vorwärtspfad 13 angeordnet. Der Schleifenfilter 12 ist in Signalflussrichtung des Signalflusses 15 dem Signaleingang 3 nachgelagert. Der Schleifenfilter 12 ist in Signalflussrichtung des Signalflusses 15 der Korrektureinheit 4 vorgelagert.

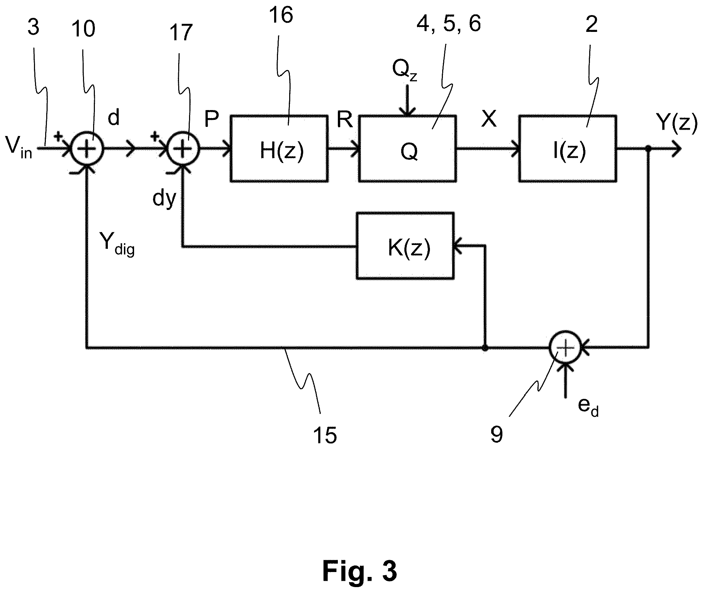

Figur 3 zeigt ein Flussdiagramm zur Audiosignalverarbeitung für den piezoelektrischen Lautsprecher 2.

In den Signaleingang 3 kann das digitale Audiosignal $V_{in}$ eingespeist werden. In Signalflussrichtung des Signalflusses 15 dem Signaleingang 3 nachgeordnet folgt die erste Additionsstelle 10. An der ersten Additionsstelle 10 kann das digitale Audiosignal $V_{in}$ mit einem digitalen Rückführsignal $Y_{dig}$ verglichen werden. Beispielsweise kann eine Differenz aus den beiden Signalen gebildet werden. Beispielsweise kann $d = V_{in} - Y_{dig}$ gebildet werden. Dabei kann vorteilhafterweise das digitale Rückführsignal $Y_{dig}$ eines vorherigen Systemtakts der Vorrichtung 1 mit dem aktuellen digitalen Audiosignal $V_{in}$ verglichen werden. Beispielsweise kann $d = V_{in}(n) - Y_{dig}(n-1)$ ermittelt werden. d kann somit die Regelabweichung sein. d ist auch der Wert, um den die Spannung des piezoelektrischen Lautsprechers 2 angepasst werden muss. Diese kann Null sein, wenn am piezoelektrischen Aktor des Lautsprechers 2 eine Spannung anliegt, die anliegen soll, um gemäß dem digitalen Audiosignal $V_{in}$ den entsprechenden Schall zu erzeugen. Aufgrund von Fehlern, beispielsweise durch die Nichtlinearitäten des piezoelektrischen Lautsprechers 2, des ersten Signalrauschens $Q_z$ und/oder eines zweiten Signalrauschens $e_d$, kann jedoch eine Regelabweichung d von ungleich Null auftreten.

Die Regelabweichung d wird in Signalflussrichtung des Signalflusses 15 zu einer zweiten Additionsstelle 17 geführt. In der zweiten Additionsstelle 17 kann die Regelabweichung d mit einer Spannungsänderung dy des piezoelektrischen Lautsprechers 2 verglichen werden. dy kann eine Differenz von aufeinanderfolgenden Spannungen des piezoelektrischen Lautsprechers 2 definiert sein. Beispielsweise kann die zweite Additionsstelle 17 eine Differenz zwischen der Regelabweichung d und der Spannungsänderung dy bilden. Beispielsweise kann gemäß dem vorliegenden Beispiel $P = d - dy$ gebildet werden.

Das Eingangssignal P kann in Signalflussrichtung des Signalflusses 15 der Rauschformungseinheit 16 zugeführt werden. Die Rauschformungseinheit 16 kann eine Systemfunktion $H(z)$ aufweisen. Ferner kann die Rauschformungseinheit eine Signal-Übertragungsfunktion $STF_d$ aufweisen, die gemäß einer ersten Formel definiert ist:

$$STF_d = \frac{X}{d} = \frac{H(z)}{[1 + I(z) * (1 + K(z))H(z)]}$$

Die Signal-Übertragungsfunktion $STF_d$ kann das Verhalten beschreiben, wie sich die Regelabweichung d bis zu einer Stellgröße X, vorzugsweise für ein lineares System, verändert. In der oder den Formeln ist $H(z)$ die Systemfunktion, $I(z)$ die Lautsprecherfunktion, $K(z)$ die Umkehrfunktion von $I(z)$, d die Regelabweichung und X die Stellgröße für den Lautsprecher. X kann somit die Spannung sein, mit der der Lautsprecher 2 aufgeladen wird und diese kann analog sein.

Mit Hilfe der Signal-Übertragungsfunktion STF$_d$ kann ferner die Regelabweichung d um eine Periode der Systemabtastfrequenz bzw. der Arbeitsfrequenz verschoben werden. Die Regelabweichung d kann dabei um eine Periode verzögert werden. Verschiedene Systemfunktionen H(z) können zu verschiedenen Signal-Übertragungsfunktionen STF$_d$ führen.

In Signalflussrichtung des Signalflusses 15 ist der Rauschformungseinheit 16 ein Digital/Analog-Wandler Q angeordnet, der die digitale Korrektureinheit 4, den PWM-Wandler 5 und die Leistungsstufe 6 umfassen kann. Dem Digital/Analog-Wandler Q kann das Eingangssignal R bereitgestellt werden. Das Eingangssignal R kann als R = (d - dy)H(z) = P*H(z) definiert sein. Der Digital/Analog-Wandler Q weist ferner die Störgröße Q$_z$ auf, welche in Figur 3 schematisch in den Digital/Analog-Wandler Q führt. Die Störgröße Q$_z$ entspricht hier dem ersten Signalrauschen Q$_z$, das durch die Korrektureinheit 4, den PWM-Generator 5, die Leistungsstufe 6 und/oder den piezoelektrischen Lautsprecher 2 ausgebildet werden kann.

Die Verarbeitung des ersten Signalrauschens Q$_z$ kann mit Hilfe einer Rauschformungs-Übertragungsfunktion NTF$_d$ beschrieben werden, wobei diese Verarbeitung von der Rauschformungseinheit 16 ausgeführt werden kann. Die Rauschformungs-Übertragungsfunktion NTF$_d$ kann dabei gemäß einer zweiten Formel wie folgt definiert sein:

$$NTF_d = \frac{X}{Q_z} = \frac{1}{[1 + I(z) * (1 + K(z))H(z)]}$$

Eine Stellgrößen-Übertragungsfunktion X(z) kann für eine beispielhafte Systemfunktion H(z) ferner gemäß einer dritten Formel wie folgt definiert sein:

$$X(z) = d * STF_d + Q_z * NTF_d = z^{-1} * d + Q_z * (1 - z^{-1})$$

Darin sind STF$_d$ die Signal-Übertragungsfunktion und NTF$_d$ die Rauschformungs-Übertragungsfunktion. X(z) hängt dabei von der Wahl der Systemfunktion H(z) ab.

Y(z) wird für eine beispielhafte Systemfunktion H(z) gemäß einer folgenden vierten Formel definiert sein:

$$Y(Z) = V_{in} \frac{STF_d * I(z)}{(1 + STF_d * I(z))} + Q_z \frac{NTF_d * I(z)}{(1 + NTF_d * I(z))} = V_{in} * z^{-1} + Q_z(1 - z^{-1})$$

Gemäß dieser vierten Formel kann die Rauschenergie des ersten Signalrauschens Q$_z$ im hörbaren Wellenlängenspektrum gedämpft werden. Die Rauschenergie des ersten Signalrauschens Q$_z$ kann in einen hohen Frequenzbereich verschoben werden, bei dem das menschliche Gehör die Rauschenergie des ersten Signalrauschens Q$_z$ nicht mehr wahrnehmen kann und infolgedessen die Tonqualität verbessert ist. Y(z) hängt dabei von der Wahl der Systemfunktion H(z) ab.

Die Regelgröße Y(z) in Form der Spannung des piezoelektrischen Lautsprechers 2 kann mit Hilfe des A/D-Wandlers 9 digitalisiert werden. Durch die Digitalisierung kann ein Quantisierungsfehler bzw. ein Quantisierungsrauschen auftreten, welches sich im zweiten Signalrauschen e$_d$ befindet. Wird die Auflösung des A/D-Wandlers 9 hoch genug gewählt, beispielsweise 12 Bit, 14 Bit oder 16 Bit, kann das zweite Signalrauschen e$_d$ vernachlässigt werden. Mittels der Rauschformungseinheit 16 kann beispielsweise nur das erste Signalrauschen Q$_z$ aus dem hörbaren Frequenzbereich verschoben werden.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

**Bezugszeichenliste**

1    Vorrichtung zur Audiosignalverarbeitung
2    piezoelektrischer Lautsprecher
3    Signaleingang
4    digitale Korrektureinheit

| | |
|---|---|
| 5 | digitaler PWM-Generator |
| 6 | Leistungsstufe |
| 7 | Rückkopplung |
| 8 | Energieversorgung |
| 9 | Analog/Digital-Wandler |
| 10 | erste Additionsstelle |
| 11 | Rauschformungsblock |
| 12 | Schleifenfilter |
| 13 | Vorwärtspfad |
| 14 | Rückkopplungspfad |
| 15 | Signalfluss |
| 16 | Rauschformungseinheit |
| 17 | zweite Additionsstelle |

| | |
|---|---|
| $V_{in}$ | digitales Audiosignal |
| d | Regelabweichung |
| dy | Spannungsänderung am piezoelektrischen Lautsprecher |
| P | Eingangssignal Rauschformungseinheit |
| R | Eingangssignal Digital/Analog-Wandler |
| $Q_z$ | erstes Signalrauschen |
| Q | Digital/Analog-Wandler |
| X | Stellgröße |
| I(z) | Lautsprecherfunktion |
| Y(z) | Regelgröße |
| H(z) | Systemfunktion |
| K(z) | Umkehrfunktion von I(z) |
| $e_d$ | zweites Signalrauschen |
| $Y_{dig}$ | digitales Rückführsignal |
| $STF_d$ | Signal-Übertragungsfunktion |
| $NTF_d$ | Rauschformungs-Übertragungsfunktion |

## Patentansprüche

1. Vorrichtung (1) zur Audiosignalverarbeitung für einen piezoelektrischen Lautsprecher (2) zum Erzeugen von Schallwellen im hörbaren Wellenlängenspektrum

mit einem Signaleingang (3) für ein digitales Audiosignal ($V_{in}$),
mit einer digitalen Korrektureinheit (4) zur Korrektur einer Nichtlinearität des Lautsprechers (2),
mit einem digitalen PWM-Generator (5), mit dem das von der Korrektureinheit (4) korrigierte Signal in ein pulsweitenmoduliertes Schaltsignal umwandelbar ist,
mit einer Leistungsstufe (6), die mit dem von dem PWM-Generator (5) umgewandelten Schaltsignal derart ansteuerbar ist, dass ein piezoelektrischer Aktor des Lautsprechers (2) zum Auslenken einer Membran mit einer Spannung (X) aufladbar ist, und
mit einer einen Regelkreis ausbildenden Rückkopplung, mit der die Spannung als Rückführsignal (Y(z), $Y_{dig}$) rückkoppelbar ist,
wobei das Rückführsignal (Y(z), $Y_{dig}$) im bestimmungsgemäßen Gebrauch im hörbaren Frequenzbereich ein von der Korrektureinheit (4), dem PWM-Generator (5), der Leistungsstufe (6) und/oder dem piezoelektrischen Lautsprecher (2) verursachtes erstes Signalrauschen ($Q_z$) aufweist,
wobei die Vorrichtung (1) eine Rauschformungseinheit (16) aufweist, die derart ausgebildet und/oder derart in den Regelkreis implementiert ist, dass mittels dieser eine Rauschenergie des ersten Signalrauschens ($Q_z$) der Korrektureinheit (4), des PWM-Generators (5), der Leistungsstufe (6) und/oder des piezoelektrischen Lautsprechers (2) außerhalb des hörbaren Frequenzbereichs, nämlich in einen Hochfrequenzbereich, verschiebbar ist,
**dadurch gekennzeichnet,**
**dass** die Rauschformungseinheit (16) eine Signal-Übertragungsfunktion ($STF_d$) umfasst, mittels der anhand einer Regelabweichung (d) zwischen dem digitalen Audiosignal ($V_{in}$) und dem digitalen Rückführsignal ($Y_{dig}$) eine Stellgröße (X) zum Ansteuern des Lautsprechers (2) bestimmbar ist.

**2.** Vorrichtung nach dem vorherigen Anspruch, **dadurch gekennzeichnet, dass** die Rauschenergie des ersten Signalrauschens ($Q_z$) mittels der Rauschformungseinheit (16) in den Bereich einer Systemabtastfrequenz der Vorrichtung (1), insbesondere von 1 MHz, verschiebbar ist.

**3.** Vorrichtung nach einem oder mehreren der vorherigen Ansprüche,

**dadurch gekennzeichnet, dass** die Vorrichtung (1) als Regelkreisschaltung ausgebildet ist und/oder
dass der Regelkreis einen Vorwärtspfad (13) und zumindest einen Rückkopplungspfad (14) aufweist.

**4.** Vorrichtung nach einem oder mehreren der vorherigen Ansprüche,

**dadurch gekennzeichnet, dass** die Rauschformungseinheit (16) in Signalflussrichtung der Korrektureinheit (4) vorgelagert ist und/oder dass die Rauschformungseinheit (16) einen Rauschformungsblock (11) zum Verschieben der Rauschenergie des ersten Signalrauschens ($Q_z$) und/oder
einen Schleifenfilter (12) zur Unterdrückung von Regelkreis-Schwingungen aufweist.

**5.** Vorrichtung nach einem oder mehreren der vorherigen Ansprüche,
**dadurch gekennzeichnet, dass** die Vorrichtung (1) einen Analog/Digital-Wandler (9) aufweist, mittels dem das Rückführsignal (Y) digitalisierbar ist, wobei das umgewandelte digitale Rückführsignal ($Y_{dig}$) im bestimmungsgemäßen Gebrauch ein von dem Analog/Digital-Wandler (9) verursachtes zweites Signalrauschen ($e_d$) aufweist.

**6.** Vorrichtung nach einem oder mehreren der vorherigen Ansprüche,
**dadurch gekennzeichnet, dass** der Rauschformungsblock (11) derart ausgebildet ist, dass dieser nur das erste Signalrauschen ($Q_z$) verarbeitet.

**7.** Vorrichtung nach einem oder mehreren der vorherigen Ansprüche,
**dadurch gekennzeichnet, dass** die Signal-Übertragungsfunktion ($STF_d$) derart ausgebildet ist, dass mittels dieser die Regelabweichung (d) um eine Periode verzögerbar ist, und/oder dass die Signal-Übertragungsfunktion ($STF_d$) durch folgende erste Formel definiert ist

$$STF_d = \frac{X}{d} = \frac{H(z)}{[1 + I(z) * (1 + K(z)) H(z)]},$$

wobei H(z) die Systemfunktion, I(z) eine Lautsprecherfunktion, K(z) die Umkehrfunktion von I(z), d die Regelabweichung und X die Stellgröße für den Lautsprecher (2) ist.

**8.** Vorrichtung nach einem oder mehreren der vorherigen Ansprüche,
**dadurch gekennzeichnet, dass** die Rauschformungseinheit (16) eine Rauschformungs-Übertragungsfunktion ($NTF_d$) umfasst, mittels der die Rauschenergie des ersten Signalrauschens ($Q_z$) verschiebbar ist.

**9.** Vorrichtung nach einem oder mehreren der vorherigen Ansprüche,
**dadurch gekennzeichnet, dass** die Rauschformungs-Übertragungsfunktion ($NTF_d$) derart ausgebildet ist, dass mittels dieser niedrige Frequenzen gedämpft werden und/oder

dass die Rauschformungs-Übertragungsfunktion ($NTF_d$) durch folgende zweite Formel definiert ist

$$NTF_d = \frac{X}{Q_z} = \frac{1}{[1 + I(z) * (1 + K(z)) H(z)]},$$

wobei H(z) die Systemfunktion, I(z) eine Lautsprecherfunktion, K(z) die Umkehrfunktion von I(z), d die Regelabweichung und X die Stellgröße für den Lautsprecher (2) ist.

**10.** Vorrichtung nach einem oder mehreren der vorherigen Ansprüche,
**dadurch gekennzeichnet, dass** eine Stellgrößen-Übertragungsfunktion (X(z)) durch folgende dritte Formel definiert ist $X(z) = d * STF_d + Q_z * NTF_d$ und/oder

dass eine Regelgrößen-Übertragungsfunktion ($Y_{(z)}$) durch folgende vierte Formel definiert ist

$$Y(Z) = V_{in} \frac{STF_d * I(z)}{(1 + STF_d * I(z))} + Q_z \frac{NTF_d * I(z)}{(1 + NTF_d * I(z))}.$$

11. Vorrichtung nach einem oder mehreren der vorherigen Ansprüche,
**dadurch gekennzeichnet, dass** die Rauschformungseinheit (16) derart ausgebildet ist, dass mittels dieser die Nullstellen, Polstellen und/oder die Ordnung zumindest einer Übertragungsfunktion derart bestimmbar sind, dass ein Signal-Rausch-Verhältnis erhöht und/oder eine harmonische Verzerrung reduzierbar ist.

12. Vorrichtung nach einem oder mehreren der vorherigen Ansprüche,
**dadurch gekennzeichnet, dass** die Vorrichtung (1) eine Rechen-/Steuereinheit, insbesondere einen Mikrocontroller, umfasst, in der die Signal-Übertragungsfunktion ($STF_d$), die Rauschformungs-Übertragungsfunktion ($NTF_d$), die Stellgrößen-Übertragungsfunktion (X(z)) und/oder die Regelgrößen-Übertragungsfunktion ($Y_{(z)}$) implementiert sind.

13. Vorrichtung nach einem oder mehreren der vorherigen Ansprüche,
**dadurch gekennzeichnet, dass** in der Korrektureinheit (4) Messdaten eines standardisierten piezoelektrischen Lautsprechers (2) abgespeichert sind, die dessen nichtlineares Verhalten wiedergeben, und dass mittels der Korrektureinheit (4) unter Berücksichtigung dieser Messdaten ein Teil der Nichtlinearität des Lautsprechers (2) korrigierbar ist.

14. Verfahren zur Audiosignalverarbeitung für einen piezoelektrischen Lautsprecher (2) zum Erzeugen von Schallwellen im hörbaren Wellenlängenspektrum, insbesondere für eine Vorrichtung (1) gemäß einem oder mehreren der vorherigen Ansprüche,

bei dem ein über einen Signaleingang (3) eingespeistes digitales Audiosignal ($V_{in}$) verarbeitet wird,
bei dem eine Nichtlinearität des Lautsprechers (2) von einer digitalen Korrektureinheit (4) korrigiert wird,
das von der Korrektureinheit (4) korrigierte Signal von einem digitalen PWM-Generator (5) in ein pulsweitenmoduliertes Schaltsignal umgewandelt wird,
eine Leistungsstufe (6) mit dem von dem PWM-Generator (5) umgewandelte Schaltsignal derart angesteuert wird, dass ein piezoelektrischer Aktor des Lautsprechers (2) zum Auslenken einer Membran mit einer Spannung (X) aufgeladen wird, und
die Spannung (Y) über eine Rückkopplung eines Regelkreises als Rückführsignal ($Y_{dig}$) rückgekoppelt wird,
wobei das Rückführsignal ($Y_{dig}$) im bestimmungsgemäßen Gebrauch im hörbaren Frequenzbereich ein von der Korrektureinheit (4), dem PWM-Generator (5), der Leistungsstufe (6) und/oder dem piezoelektrischen Lautsprecher (2) verursachtes erstes Signalrauschen ($Q_z$) aufweist,
wobei mit einer Rauschformungseinheit (16) eine Rauschenergie des ersten Signalrauschens ($Q_z$) der Korrektureinheit (4), des PWM-Generators (5), der Leistungsstufe (6) und/oder des piezoelektrischen Lautsprechers (2) in einen Bereich oberhalb des hörbaren Frequenzbereichs verschoben wird, **dadurch gekennzeichnet, dass** die Rauschformungseinheit (16) eine Signal-Übertragungsfunktion ($STF_d$) umfasst, mittels der anhand einer Regelabweichung (d) zwischen dem digitalen Audiosignal ($V_{in}$) und dem digitalen Rückführsignal ($Y_{dig}$) eine Stellgröße (X) zum Ansteuern des Lautsprechers (2) bestimmt wird.

**Claims**

1. A device (1) for audio signal processing for a piezoelectric speaker (2) for generating sound waves in the audible wavelength spectrum, having a signal input (3) for a digital audio signal ($V_{in}$),

having a digital correction unit (4) for correcting a nonlinearity of the speaker (2),
having a digital PWM generator (5) by means of which the signal corrected by the correction unit (4) can be converted into a pulse-width modulated switch signal,
having a power stage (6) able to be controlled by means of the switch signal converted by the PWM generator (5) such that a piezoelectric actuator of the speaker (2) can be charged with a voltage (X) for deflecting a membrane, and
having a feedback implementing a closed-loop control circuit, by means of which the voltage can be fed back as a feedback signal (Y(z), $Y_{dig}$),

the feedback signal (Y(z), $Y_{dig}$) comprising a first signal noise ($Q_z$) caused by the correction unit (4), the PWM generator (5), the power stage (6), and/or the piezoelectric speaker (2) when used properly in the audible frequency range,

wherein the device (1) comprises a noise shaping unit (16) designed and/or implemented in the closed-loop control circuit such that a noise energy of the first signal noise ($Q_z$) of the correction unit (4), the PWM generator (5), the power stage (6), and/or the piezoelectric speaker (2) can be shifted outside of the audible frequency range by means of said unit

**characterized in that**,

the noise shaping unit (16) comprises a signal transfer function ($STF_d$) by means of which an actuating variable (X) for actuating the speaker (2) can be determined using a control deviation (d) between the digital audio signal ($V_{in}$) and the digital feedback signal ($Y_{dig}$).

2. The device according to the preceding claim, **characterized in that** the noise energy of the first signal noise ($Q_z$) can be shifted by means of the noise shaping unit (16) into the range of a system sampling frequency of the device (1), particularly of 1 MHz.

3. The device according to any one or more of the preceding claims, **characterized in that** the device (1) is designed as a closed-loop control circuit and/or
that the closed-loop control circuit comprises a forward path (13) and at least one feedback path (14).

4. The device according to any one or more of the preceding claims, **characterized in that** the noise shaping unit (16) is connected upstream of the correction unit (4) in the direction of signal flow and/or the noise shaping unit (16) comprises a noise shaping block (11) for shifting the noise energy of the first signal noise ($Q_z$) and/or
a loop filter (12) for suppressing closed-loop control circuit oscillations.

5. The device according to any one or more of the preceding claims, **characterized in that** the device (1) comprises an analog/digital converter (9) by means of which the feedback signal (Y) can be digitalized, wherein the converted digital feedback signal ($Y_{dig}$) comprises a second signal noise ($e_d$) caused by the analog/digital converter (9) when used properly.

6. The device according to any one or more of the preceding claims, **characterized in that** the noise shaping block (11) is designed for processing only the first signal noise ($Q_z$).

7. The device according to any one or more of the preceding claims, **characterized in that** the signal transfer function ($STF_d$) is implemented such that the control deviation (d) can be delayed by one period by means thereof and/or

the signal transfer function ($STF_d$) is defined by the following first formula:

$$STF_d = \frac{X}{d} = \frac{H(z)}{[1 + I(z) * (1 + K(z))H(z)]},$$

wherein H(z) is the system function, I(z) is a speaker function, K(z) is the inverse function of I(z), d is the control deviation, and X is the actuating variable for the speaker (2).

8. The device according to any one or more of the preceding claims, **characterized in that** the noise shaping unit (16) comprises a noise shaping transfer function ($NTF_d$) by means of which the noise energy of the first signal noise ($Q_z$) can be shifted.

9. The device according to any one or more of the preceding claims, **characterized in that** the noise shaping transfer function ($NTF_d$) is implemented such that low frequencies are damped by means thereof and/or the noise shaping transfer function ($NTF_d$) is defined by the following second formula:

$$NTF_d = \frac{X}{Q_z} = \frac{1}{[1 + I(z) * (1 + K(z))H(z)]},$$

wherein H(z) is the system function, I(z) is a speaker function, K(z) is the inverse function of I(z), d is the control deviation, and X is the actuating variable for the speaker (2).

10. The device according to any one or more of the preceding claims, **characterized in that** an actuating variable transfer function (X(z)) is defined by the following third formula: $X(z) = d * STF_d + Q_z * NTF_d$ and/or a controlled variable transfer function $(Y_{(z)})$ is defined by the following fourth formula:

$$Y(Z) = V_{in} \frac{STF_d * I(z)}{(1 + STF_d * I(z))} + Q_z \frac{NTF_d * I(z)}{(1 + NTF_d * I(z))}.$$

11. The device according to any one or more of the preceding claims, **characterized in that** the noise shaping unit (16) is designed such that the zeroes, poles, and/or order of at least one transfer function can be determined by means thereof such that a signal-to-noise ratio can be increased and/or a harmonic distortion can be reduced.

12. The device according to any one or more of the preceding claims, **characterized in that** the device (1) comprises a computing or controlling unit, particularly a microcontroller, in which the signal transfer function ($STF_d$), the noise shaping transfer function ($NTF_d$), the actuating variable transfer function (X(z)), and/or the controlled variable transfer function (Y(z)) are implemented.

13. The device according to any one or more of the preceding claims, **characterized in that** measurement data of a standardized piezoelectric speaker (2) is stored in the correction unit (4) for describing the nonlinear behavior thereof, and
that part of the nonlinearity of the speaker (2) can be corrected by means of the correction unit (4) by applying said measurement data.

14. A method for audio signal processing for a piezoelectric speaker (2) for generating sound waves in the audible wavelength spectrum, particularly for a device (1) according to any one or more of the preceding claims,

a digital audio signal ($V_{in}$) fed in via a signal input (3) being processed, a nonlinearity of the speaker (2) being corrected by a digital correction unit (4),
the signal corrected by the correction unit (4) being converted into a pulse-width modulated switch signal by a digital PWM generator (5),
a power stage (6) being actuated by means of the switch signal converted by the PWM generator (5) such that a piezoelectric actuator of the speaker (2) is charged with a voltage (X) for deflecting a membrane, and
the voltage (Y) being fed back as a feedback signal ($Y_{dig}$) via a feedback of a closed-loop control circuit,
the feedback signal ($Y_{dig}$) comprising a first signal noise ($Q_z$) caused by the correction unit (4), the PWM generator (5), the power stage (6), and/or the piezoelectric speaker (2) when used properly in the audible frequency range,
a noise energy of the first signal noise ($Q_z$) of the correction unit (4), the PWM generator (5), the power stage (6), and/or the piezoelectric speaker (2) is shifted out of the audible frequency range by means of a noise shaping unit (16)
**characterized in that**,
the noise shaping unit (16) comprises a signal transfer function ($STF_d$) by means of which an actuating variable (X) for actuating the speaker (2) can be determined using the control deviation (d) between the digital audio signal ($V_{in}$) and the digital feedback signal ($Y_{dig}$).

**Revendications**

1. Dispositif (1) de traitement de signaux d'audiofréquences pour un haut-parleur piézoélectrique (2) destiné à générer des ondes sonores dans le spectre de longueurs d'onde audibles

comprenant une entrée de signaux (3) pour un signal audio numérique ($V_{in}$),
comprenant une unité de correction numérique (4) destinée à corriger une non-linéarité du haut-parleur (2),
comprenant un générateur PWM numérique (5) permettant de convertir le signal corrigé par l'unité de correction (4) en un signal de commutation modulé en largeur d'impulsion,
comprenant un étage de puissance (6) qui peut être commandé avec le signal de commutation converti par le générateur PWM (5) de telle sorte qu'un actionneur piézoélectrique du haut-parleur (2) peut être chargé avec une tension (X) pour dévier un diaphragme, et

comprenant un retour formant un circuit de réglage permettant de réin-jecter la tension en tant que signal de retour (Y(z), $Y_{dig}$),

le signal de retour (Y(z), $Y_{dig}$) présentant un premier bruit de signal ($Q_z$) provoqué par l'unité de correction (4), le générateur PWM (5), l'étage de puissance (6) et/ou le haut-parleur piézoélectrique (2) lors d'une utilisation conforme aux prescriptions dans la plage de fréquences audibles,

le dispositif (1) présentant une unité de formation du bruit (16) qui est conçue et/ou mise en oeuvre dans le circuit de réglage de telle sorte qu'une énergie de bruit du premier bruit de signal ($Q_z$) de l'unité de correction (4), du générateur PWM (5), de l'étage de puissance (6) et/ou du haut-parleur piézoélectrique (2) peut être déplacée à l'extérieur de la plage de fréquences audibles, à savoir dans une plage de hautes fréquences, **caractérisé en ce que**

l'unité de formation du bruit (16) comprend une fonction de transfert de signaux ($STF_d$) permettant de déterminer une variable réglante (X) pour commander le haut-parleur (2) à l'aide d'un écart de réglage (d) entre le signal audio numérique ($V_{in}$) et le signal de retour numérique ($Y_{dig}$).

2. Dispositif selon la revendication précédente, **caractérisé en ce que** l'énergie de bruit du premier bruit de signal ($Q_z$) peut être déplacée au moyen de l'unité de formation du bruit (16) dans la plage d'une fréquence d'échantillonnage du système du dispositif (1), en particulier de 1 MHz.

3. Dispositif selon une ou plusieurs des revendications précédentes, **caractérisé en ce que** le dispositif (1) est conçu en tant que circuit de réglage et/ou

   **en ce que** le circuit de réglage présente un trajet vers l'avant (13) et au moins un chemin de retour (14).

4. Dispositif selon une ou plusieurs des revendications précédentes, **caractérisé en ce que** l'unité de formation du bruit (16) est montée en amont de l'unité de correction (4) dans la direction du flux de signaux et/ou

   **en ce que** l'unité de formation du bruit (16) présente un bloc de formation du bruit (11) pour déplacer l'énergie de bruit du premier bruit de signal ($Q_z$) et/ou
   un filtre à boucle (12) pour supprimer les oscillations du circuit de réglage.

5. Dispositif selon une ou plusieurs des revendications précédentes, **caractérisé en ce que** le dispositif (1) présente un convertisseur analogique-numérique (9) permettant de numériser le signal de retour (Y), le signal de retour numérique converti ($Y_{dig}$) présentant un deuxième bruit de signal ($e_d$) provoqué par le convertisseur analogique-numérique (9) lors d'une utilisation conforme aux prescriptions.

6. Dispositif selon une ou plusieurs des revendications précédentes, **caractérisé en ce que** le bloc de formation du bruit (11) est conçu de telle sorte qu'il ne traite que le premier bruit de signal ($Q_z$).

7. Dispositif selon une ou plusieurs des revendications précédentes, **caractérisé en ce que** la fonction de transfert de signaux (STFd) est conçue de telle sorte que l'écart de réglage (d) peut être retardé d'une période au moyen de celle-ci, et/ou

   **en ce que** la fonction de transfert de signaux (STFd) est définie par la première formule suivante

$$STF_d = \frac{X}{d} = \frac{H(z)}{[1+I(z)*(1+K(z))H(z)]},$$

dans lequel H(z) est la fonction système, I(z) une fonction de haut-parleur, K(z) la fonction inverse de I(z), d l'écart de réglage et X la variable réglante pour le haut-parleur (2).

8. Dispositif selon une ou plusieurs des revendications précédentes, **caractérisé en ce que** l'unité de formation du bruit (16) comprend une fonction de transfert de formation du bruit ($NTF_d$) permettant de déplacer l'énergie de bruit du premier bruit de signal ($Q_z$).

9. Dispositif selon l'une ou plusieurs des revendications précédentes, **caractérisé en ce que** la fonction de transfert de formation du bruit (NTFd) est telle que les basses fréquences sont amorties au moyen de celle-ci, et/ou

   **en ce que** la fonction de transfert de formation du bruit (NTFd) est définie par la deuxième formule suivante

$$NTF_d = \frac{X}{Q_z} = \frac{1}{[1+I(z)*(1+K(z))H(z)]},$$

dans laquelle H(z) est la fonction système, I(z) une fonction de haut-parleur, K(z) la fonction inverse de I(z), d l'écart de réglage et X la variable réglante pour le haut-parleur (2).

**10.** Dispositif selon une ou plusieurs des revendications précédentes, caractérisé en ce qu'une fonction de transfert de variable réglante (X(z)) est définie par la troisième formule suivante
X(z) = d * STF_d + Q_z * NTF_d et/ou
en ce qu'une fonction de transfert de variable réglante (Y(z)) est définie par la quatrième formule suivante

$$Y(Z) = V_{in} \frac{STF_d*I(z)}{(1+STF_d*I(z))} + Q_z \frac{NTF_d*I(z)}{(1+NTF_d*I(z))}.$$

**11.** Dispositif selon une ou plusieurs des revendications précédentes, **caractérisé en ce que** l'unité de formation du bruit (16) est conçue de telle sorte qu'elle permet de déterminer les zéros, les pôles et/ou l'ordre d'au moins une fonction de transfert de telle sorte qu'un rapport signal-bruit soit augmenté et/ou qu'une distorsion harmonique puisse être réduite.

**12.** Dispositif selon une ou plusieurs des revendications précédentes, **caractérisé en ce que** le dispositif (1) comprend une unité de calcul/commande, en particulier un microcontrôleur, dans laquelle sont implémentées la fonction de transfert de signaux (STF_d), la fonction de transfert de formation du bruit (NTF_d), la fonction de transfert de variables réglantes (X(z)) et/ou la fonction de transfert de variables de réglage (Y_{(z)}).

**13.** Dispositif selon une ou plusieurs des revendications précédentes, **caractérisé en ce que** des données de mesure d'un haut-parleur piézoélectrique standardisé (2) sont mémorisées dans l'unité de correction (4), lesquelles reproduisent son comportement non linéaire, et
**en ce qu'**une partie de la non-linéarité du haut-parleur (2) peut être corrigée au moyen de l'unité de correction (4) en tenant compte de ces données de mesure.

**14.** Procédé de traitement de signaux d'audiofréquences pour un haut-parleur piézoélectrique (2) destiné à générer des ondes sonores dans le spectre de longueurs d'onde audibles, en particulier pour un dispositif (1) selon une ou plusieurs des revendications précédentes, dans lequel un signal audio numérique (V_{in}) injecté par une entrée de signaux (3) est traité,

dans lequel une non-linéarité du haut-parleur (2) est corrigée par une unité de correction numérique (4),
le signal corrigé par l'unité de correction (4) est converti par un générateur PWM numérique (5) en un signal de commutation modulé en largeur d'impulsion,
un étage de puissance (6) est commandé avec le signal de commutation converti par le générateur PWM (5) de telle sorte qu'un actionneur piézoélectrique du haut-parleur (2) est chargé avec une tension (X) pour dévier un diaphragme, et
la tension (Y) est réinjectée par un retour d'un circuit de réglage en tant que signal de retour (Y_{dig}),
le signal de retour (Y_{dig}) présentant un premier bruit de signal (Q_z) provoqué par l'unité de correction (4), le générateur PWM (5), l'étage de puissance (6) et/ou le haut-parleur piézoélectrique (2) lors d'une utilisation conforme aux prescriptions dans la plage de fréquences audibles,
dans lequel une énergie de bruit du premier bruit de signal (Q_z) de l'unité de correction (4), du générateur PWM (5), de l'étage de puissance (6) et/ou du haut-parleur piézoélectrique (2) est déplacée dans une plage au-dessus de la plage de fréquences audibles avec une unité de formation du bruit (16), **caractérisé en ce que** l'unité de formation du bruit (16) comprend une fonction de transfert de signaux ($\overline{STF_d}$) permettant de déterminer une variable réglante (X) pour commander le haut-parleur (2) à l'aide d'un écart de réglage (d) entre le signal audio numérique (V_{in}) et le signal de retour numérique (Y_{dig}).

**Fig. 1**

EP 3 595 332 B1

**Fig. 2**

**Fig. 3**

EP 3 595 332 B1

**IN DER BESCHREIBUNG AUFGEFÜHRTE DOKUMENTE**

**In der Beschreibung aufgeführte Patentdokumente**

- US 20100271147 A1
- WO 2012055968 A1